(19) Europäisches Patentamt
European Patent Office
Office européen des brevets

(11) Publication number: 0 145 254 B1

# (12) EUROPEAN PATENT SPECIFICATION

(45) Date of publication of patent specification: 13.01.88

(51) Int. Cl.$^4$: H 03 H 11/24

(21) Application number: 84307636.5

(22) Date of filing: 06.11.84

## (54) Voltage converting circuit.

(30) Priority: 11.11.83 JP 212083/83

(43) Date of publication of application: 19.06.85 Bulletin 85/25

(45) Publication of the grant of the patent: 13.01.88 Bulletin 88/02

(84) Designated Contracting States: DE FR GB

(56) References cited:
US-A-4 197 511

IBM TECHNICAL DISCLOSURE BULLETIN, vol. 26, no. 4, September 1983, page 2073, New York, US; R.D. BURKE: "FET voltage regulator circuit"

(73) Proprietor: FUJITSU LIMITED
1015, Kamikodanaka Nakahara-ku
Kawasaki-shi Kanagawa 211 (JP)

(72) Inventor: Takemae, Yoshihiro c/o FUJITSU LIMITED
Patent Department 1015 Kamikodanaka Nakahara-ku
Kawasaki-shi Kanagawa 211 (JP)

(74) Representative: Sunderland, James Harry et al
HASELTINE LAKE & CO Hazlitt House 28
Southampton Buildings Chancery Lane
London WC2A 1AT (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 145 254 B1

**Description**

This invention relates to a voltage converting circuit operable to provide an output voltage level intermediate with respect to power supply voltage.

It is often required in MIS type integrated circuits to provide a constant voltage having an intermediate level with respect to the level of a power supply voltage supplied from an external circuit. That is, it is frequently required to supply a voltage of a level intermediate the levels of the two poles of a power supply (the level of one pole usually being taken to be zero voltage, the level of the other usually being taken to be the power supply voltage). For instance, an intermediate level of, for example, 2.5V is required to be steadily applied to a common capacitor electrode incorporated in memory cells in a MIS type dynamic random access memory operative with a power supply voltage of 5V.

Such an intermediate level can be obtained using a resistance dividing circuit as shown in Fig. 1. In the circuit of Fig. 1, resistors $R_1$, $R_2$ divide a power supply voltage $V_{cc}$ in order to obtain an intermediate voltage $V_{cc}'$ and apply it to a load circuit L. When $R_1=R_2$, $V_{cc}'=V_{cc}/2$. However, if load circuit L consumes a current which is so high that it cannot be ignored, this relationship between $V_{cc}'$ and $V_{cc}$ cannot be maintained. Moreover, in Fig. 1, the resistors $R_1$, $R_2$ are connected in series between a line carrying the power supply voltage $V_{cc}$ of +5V (the first ($V_{cc}$) power source line) for example, and a line carrying ground or zero volts $V_{ss}$ for the supply of power (the second ($V_{ss}$) power source line), and a current always flows from the $V_{cc}$ line to the $V_{ss}$ line through $R_1$, $R_2$ (when the power supply is ON) and thereby a large amount of power is consumed. This is one disadvantage of the circuit of Fig. 1. Such power consumption can be reduced by making the resistance values of the resistors $R_1$, $R_2$ large. However, if large resistance values are used, the voltage $V_{cc}'$ of node $N_1$ will suffer large fluctuations with variations in the load current.

The circuit shown in Fig. 2 provides reduced power consumption and reduced fluctuations of load voltage $V_{cc}'$ with regard to variations of load current, as compared with the circuit of Fig. 1. In the circuit of Fig. 2, a divided voltage obtained through the resistors $R_1$, $R_2$ is applied to the gate of a MIS transistor $Q_1$ and an output of the transistor $Q_1$ is applied to the load circuit L. $Q_1$ constitutes an output transistor of low output impedance and load current flows through the drain and source of transistor $Q_1$ but does not flow into the voltage dividing circuit $R_1$, $R_2$. Therefore, there is little or no change of load voltage $V_{cc}'$ with variation in load current and since the dividing circuit only applies a voltage to the gate of MIS transistor $Q_1$, the dividing circuit can be provided with a high resistance value, thus reducing power consumption. Since there is a relationship, $V_N-V_{th}=V_{cc}'$ between the voltage $V_N$ of node $N_1$ and load voltage $V_{cc}'$, when $V_{cc}'=V_{cc}/2$ is required, $V_N$ is selected to a value which satisfies the relationship, $V_N=V_{th}+V_{cc}/2$. $V_{th}$ is a gate threshold voltage of MIS transistor $Q_1$.

However, the circuit of Fig. 2 has a problem in that threshold voltage $V_{th}$ of the transistor $Q_1$ directly affects load voltage $V_{cc}'$. $V_{th}$ varies in integrated circuit manufacturing processes and thereby load voltage $V_{cc}'$ fluctuates from one integrated circuit to another.

Namely, a desired resistance ratio of two resistors formed in an integrated circuit can be achieved with only a small error or variation from one integrated circuit to another, but $V_{th}$ cannot be set so reliably. For example, a resistance ratio error of as little as 1% or less can be achieved. Therefore, a voltage $V_N$ of node $N_1$ can be set accurately. However, gate threshold voltage of an MIS transistor is easily affected by manufacturing process fluctuations and an error of 0.2V can easily arise. This error means, for example, that an error of about 10% can easily arise in a circuit which is intended to generate a desired output voltage $V_{cc}'$ of 2.5V.

According to the present invention, there is provided a voltage converting circuit, for connection to first and second power supply lines, which provide a power supply voltage therebetween when a power supply is connected to the lines, operable when in use to provide a converted output voltage of a level which is a predetermined fraction of the power supply voltage; the circuit comprising:—

an output MIS transistor having a gate, a terminal connected to a power supply line, and a terminal for delivering the said converted output voltage; and

gate control means, operable to provide the gate of the output MIS transistor with a gate control voltage, comprising a series connection, between the first and second power supply lines of impedance elements operable to provide voltage division in accordance with the said predetermined fraction, characterised in that

the series connection further includes at least one compensation MIS transistor, such that the voltage of a node between two elements of the series connection differs from the level of the said converted output voltage by an amount dependent upon MIS transistor gate threshold voltage, the voltage of the said node being employed to provide the said gate control voltage, whereby the said level of the converted output voltage is provided irrespective of the value of the MIS transistor gate threshold voltage, by mutual cancellation of the effect of an error in the gate threshold voltage of the output MIS transistor upon operation of that transistor and the effect of such an error in gate threshold voltage upon the voltage of the said node.

An embodiment of this invention can provide a voltage converting circuit which outputs an intermediate level with respect to power source voltage, suitable for use in an MIS integrated circuit.

An embodiment of this invention can provide a

voltage converting circuit with a low power consumption.

An embodiment of this invention can provide a voltage converting circuit with an output MIS transistor which affords a small output impedance.

An embodiment of this invention provides that output voltage of a voltage converting circuit is unaffected by manufacturing variation of threshold voltage $V_{th}$ of the output MIS transistor of the voltage converting circuit.

Reference is made, by way of example, to the accompanying drawings, in which:—

Fig. 1 is a schematic circuit diagram of a previous voltage converting circuit;

Fig. 2 is a schematic circuit diagram of another previous voltage converting circuit;

Figs. 3 to 7 are respective schematic circuit diagrams of voltage converting circuits in accordance with respective embodiments of this invention; and

Figs. 8(a), and (b), are graphs illustrating change of converted voltage output with respect to time after a power supply is turned ON, respectively for a previous voltage converting circuit and a voltage converting circuit embodying this invention.

In Figs. 3 to 8, items similar to those appearing in Fig. 1 and Fig. 2 are given the same reference signs.

In comparison with the previous circuit shown in Fig. 2, the circuit embodying the present invention and shown in Fig. 3 is different in that MIS transistors $Q_2$, $Q_3$ are provided in connection with the voltage dividing circuit part (in the gate voltage control circuit part) of the voltage converting circuit.

In the circuit of Fig. 3, a pair of N channel MIS transistors $Q_2$, $Q_3$ are connected in series with the resistor elements $R_1$ and $R_2$ which establish a voltage dividing ratio. A divided output voltage provided by the series connection of resistor elements $R_1$, $R_2$ and MIS transistors $Q_2$, $Q_3$ is applied from the node $N_1$ to the gate of output N channel MIS transistor $Q_1$. The transistors $Q_2$, $Q_3$ are provided for affording compensation in respect of gate threshold voltage. The number of such "compensation" transistors can be altered, the number required depending on the desired voltage dividing ratio. The circuit of Fig. 3 is provided for outputting a voltage of $V_{cc}/2$ (i.e. for a desired voltage dividing ratio of 1/2) and two transistors $Q_2$ and $Q_3$ are required in this case. The circuit of Fig. 3 operates normally when a voltage of power source voltage supply line ($V_{cc}$) is higher than the normal voltage $V_{cc}/2$ to be output. In this case, the voltage of node $N_2$ is $V_{th}$, the voltage of node $N_3$ is $2\times V_{th}$. When $R_1=R_2$, the voltage of node $N_1$ is

$$(V_{cc}-2V_{th})/2+2V_{th}=V_{cc}/2+V_{th}.$$

Since the transistors $Q_1$ to $Q_3$ are formed by the same processes on a semiconductor substrate, these transistors can be considered to have the same threshold voltage. When the node $N_1$ has the voltage given above, the load voltage $V_{cc}'$ is $V_{cc}/2$, which is lower than the voltage of node $N_1$ by $V_{th}$. Thereby, a voltage $V_{cc}'$, irrespective of threshold voltage of the transistors used, can be supplied to the load L.

Fig. 4 illustrates another embodiment of this invention. The circuit of Fig. 3 operates correctly if the load L always consumes current drawn through the transistor $Q_1$ (i.e. if current flows through

$$V_{cc}-Q_1-L-V_{ss}).$$

Fig. 3 does not take into account the possibility of current flowing out from the load L. The circuit of Fig. 4 can operate properly even when current flows out of the load L. In the circuit of Fig. 4, the circuit portion formed by $R_1$, $R_2$, $Q_3$, $Q_2$, $Q_1$ can be seen to be the same as the corresponding part in Fig. 3, and load voltage $V_{cc}'$ is held thereby to $V_{cc}/2$, irrespective of $V_{th}$ of transistors $Q_1$ to $Q_3$, when the load consumes current drawn through $Q_1$ (when current flows from $V_{cc}$ to $Q_1$ to the load and hence to $V_{ss}$). The MIS transistors $Q_4$, $Q_5$, $Q_6$ and resistors $R_3$, $R_4$ form a circuit portion which holds the load voltage $V_{cc}'$ to $V_{cc}/2$ in a case in which a current flows into the power supply $V_{ss}$ through the transistor $Q_4$ from the load L. $Q_4$, $Q_5$, $Q_6$ are P channel transistors, whereas $Q_1$, $Q_2$, $Q_3$ are N channel transistors. Voltage of node $N_6$ is $V_{cc}-V_{thp}$, a voltage of node $N_5$ is $V_{cc}-2V_{thp}$ and a voltage of node $N_4$ is

$$(V_{cc}-2V_{thp})/2=V_{cc}/2-V_{thp}$$

when $R_3=R_4$. $V_{thp}$ is a gate threshold voltage of p channel transistor $Q_4$ ($Q_5$ and $Q_6$). Since voltage of node $N_4$ is lower than $V_{cc}'$ by $V_{th}$ of $Q_4$, $V_{cc}'$ becomes $V_{cc}/2$. In the circuit of Fig. 4, load voltage can be set constant irrespective of $V_{th}$ and $V_{thp}$, for cases in which current flows into the load and in which current flows out from the load.

It is desirable in actual design of the circuit of Fig. 4 to assuredly avoid the occurrence of a steady current through the series connection of transistors $Q_1$ and $Q_4$ between $V_{cc}$ and $V_{ss}$. This is achieved by providing a small difference between the voltage dividing ratio afforded by resistors $R_1$, $R_2$ and the voltage dividing ratio afforded by resistors $R_3$, $R_4$. For example, the voltage of node $N_1$ should advantageously be $V_{cc}/2+V_{th}$ minus a few or several tens of milliVolts and the voltage of node $N_4$ should be $V_{cc}/2-V_{thp}$ plus a few or several tens of milliVolts. Thereby, when the output voltage $V_{cc}'$ is $V_{cc}/2$, both output transistors $Q_1$, $Q_4$ are set to a cut-off condition. If the output voltage $V_{cc}'$ rises or falls, one or other of the output transistors $Q_1$ or $Q_4$ becomes ON selectively and suppresses the rise or fall of voltage $V_{cc}'$.

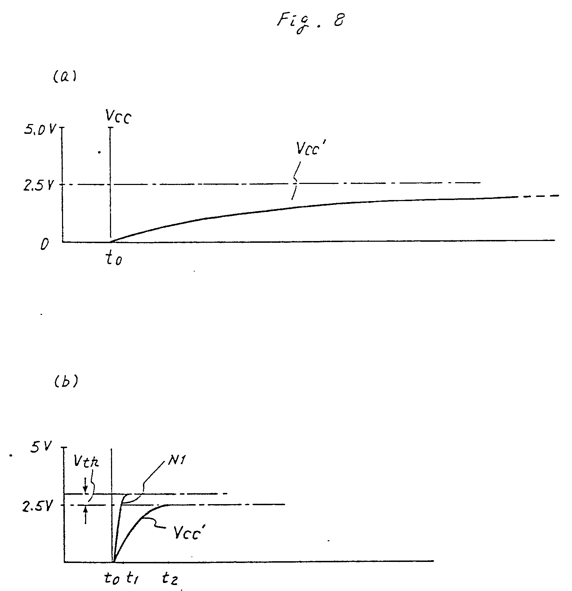

Fig. 5 and Fig. 6 illustrate respective further embodiments of this invention. The embodiment of Fig. 5 functions to hold a load voltage $V_{cc}'$ to $V_{cc}/3$, whilst the embodiment of Fig. 6 functions to hold $V_{cc}'$ to $2V_{cc}/3$.

In Fig. 5 the voltage of node $N_7$ is $3V_{th}$ and the

resistance values of resistors $R_1$, $R_2$ are selected to have the relationship $R_1=2R_2$. The voltage of node $N_1$ in Fig. 5 thus becomes equal to

$$(V_{cc}-3V_{th})/3+3V_{th}=V_{cc}/3+2V_{th}$$

and the load voltage $V_{cc}'$ is lower than this level by $2V_{th}$ due to the voltage drop ($V_{th}$) across transistors $Q_8$ and $Q_1$ and thus becomes equal to $V_{cc}/3$.

In Fig. 6, the voltage of node $N_7$ is $3V_{th}$ and the resistance values of resistors $R_1$, $R_2$ are selected to have the relationship $2R_1=R_2$. The voltage of node $N_1$ in Fig. 6 is thus

$$2(V_{cc}-3V_{th})/3+3V_{th}=2V_{cc}/3+V_{th},$$

and the load voltage $V_{cc}'$ is lower than this voltage by $V_{th}$ (the voltage drop$-V_{th}-$across $Q_1$) and becomes equal to $2V_{cc}/3$.

In general, a load voltage of $V_{cc}'=mV_{cc}/n$ can be obtained by using n transistors as arranged in the manner of transistors $Q_2$, $Q_3$,..., inserted in series with the resistors ($R_1$, $R_2$) of voltage dividing circuit, by using $(n-m-1)$ transistors arranged in the manner of transistors $Q_8$...inserted into the gate circuit of output transistor $Q_1$, and by setting a resistance ratio $R_2/(R_1+R_2)$ to m/n. Thereby, a variety of load voltages $V_{cc}'$ which are not affected by $V_{th}$ can be obtained. m and n are integers and $m<n$.

When in a previous voltage converting circuit resistance values (e.g. of $R_1$, $R_2$) are made large in order to reduce power consumption in the voltage dividing circuit, the time constant of the voltage converting circuit becomes large and the rising edge of load voltage $V_{cc}'$ when power (i.e. power source $V_{cc}$) is turned on is gently sloping as shown in Fig. 8(a). When a transistor $Q_1$ is used as in the case of the embodiment of the present invention of Fig. 3, load voltage $V_{cc}'$ rises quickly when power is turned on, as shown in Fig. 8(b), so operation of the load circuit can be commenced substantially immediately.

In the circuit of Fig. 3, resistor $R_2$ may be moved from the illustrated location, for example to a location between $Q_3$ and $V_{ss}$. The same result is obtained. Moreover, such a disposition of $R_2$ is advantageous in that with this disposition each transistor $Q_1$, $Q_2$, or $Q_3$ suffers a similar back gate bias effect on its own $V_{th}$ since the source voltages of $Q_2$, $Q_3$ are in this case raised to a value close to that of $Q_1$ and thereby, $V_{th}$ of $Q_2$ and $Q_3$ become more exactly equal to that of $Q_1$.

Fig. 7 shows an embodiment of the present invention in which resistors $R_1$, $R_2$ of Fig. 3 are replaced by depletion transistors $T_1$ to $T_n$, $T_1'$ to $T_n'$.

In general, resistance of a polysilicon layer or diffusion layer used in a MIS dynamic memory is as little as a few or several tens of ohms/square. To obtain a resistance value of several hundreds of k-ohms for the resistors $R_1$, $R_2$ by using such resistance layers, it is necessary to employ an area of several hundreds or thousand square micrometers. In order to avoid this, it is recommended to use one or a plurality of depletion transistors connected in series in place of such resistors. Thereby, only a small area is employed for a similar current reduction.

## Claims

1. A voltage converting circuit, for connection to first ($V_{cc}$) and second ($V_{ss}$) power supply lines which provide a power supply voltage ($V_{cc}$) therebetween when a power supply is connected to the lines, operable when in use to provide a converted output voltage ($V_{cc}'$) of a level ($mV_{cc}/n$) which is a predetermined fraction (m/n) of the power supply voltage ($V_{cc}$), the circuit comprising:—

an output MIS transistor ($Q_1$, $Q_4$) having a gate, a terminal connected to a power supply line, and a terminal for delivering the said converted output voltage ($V_{cc}'$); and

gate control means ($R_1$, $R_2$, $Q_2$, $Q_3$; $R_3$, $R_4$, $Q_5$, $Q_6$; $R_1$, $R_2$, $Q_2$, $Q_3$, $Q_7$; $R_1$, $R_2$, $Q_2$, $Q_3$, $Q_7$, $Q_8$; $T_1$ to $T_n$, $T_1'$ to $T_n'$, $Q_2$, $Q_3$), operable to provide the gate of the output MIS transistor ($Q_1$, $Q_4$) with a gate control voltage, comprising a series connection, between the first ($V_{cc}$) and second ($V_{ss}$) power supply lines, of impedance elements ($R_1$, $R_2$; $R_3$, $R_4$; $T_1$ to $T_n$; $T_1'$ to $T_n'$) operable to provide voltage division in accordance with the said predetermined fraction, characterised in that

the series connection further includes at least one compensation MIS transistor ($Q_2$, $Q_3$; $Q_5$, $Q_6$; $Q_2$, $Q_3$, $Q_7$), such that the voltage of a node ($N_1$) between two elements of the series connection differs from the level of the said converted output voltage by an amount dependent upon MIS transistor gate threshold voltage, the voltage of the said node ($N_1$) being employed to provide the said gate control voltage, whereby the said level of the converted output voltage ($V_{cc}'$) is provided irrespective of the value of the MIS transistor gate threshold voltage, by mutual cancellation of the effect of an error in the gate threshold voltage ($V_{th}$, $V_{thp}$) of the output MIS transistor ($Q_1$, $Q_4$) upon operation of that transistor and the effect of such an error in gate threshold voltage upon the voltage of the said node ($N_1$).

2. A voltage converting circuit as claimed in claim 1, wherein the impedance elements comprise a plurality of resistor elements ($R_1$, $R_2$; $R_3$, $R_4$).

3. A voltage converting circuit as claimed in claim 1, wherein the impedance elements comprise a plurality of depletion MIS transistors ($T_1$ to $T_n$, $T_1'$ to $T_n'$).

4. A voltage converting circuit as claimed in claim 1, 2 or 3, wherein the series connection comprises a plurality of compensation MIS transistors ($Q_2$, $Q_3$; $Q_5$; $Q_6$; $Q_2$, $Q_3$, $Q_7$), the number (n) of which is selected in accordance with the said predetermined fraction.

5. A voltage converting circuit as claimed in any preceding claim, wherein the series connection includes a plurality of first compensation MIS

transistors ($Q_2$, $Q_3$; $Q_5$, $Q_6$; $Q_2$, $Q_3$, $Q_7$), and wherein the gate control means further comprises at least one second compensation MIS transistor ($Q_8$) connected between the gate of the output MIS transistor and the power supply line to which a terminal of the output MIS transistor is connected, with its gate connected to the said node ($N_1$), the number (n) of the first compensation MIS transistor(s) being arranged so as to provide the gate of the output MIS transistor ($Q_1$) with a voltage having a level of the constant converted output voltage ($V_{cc}'$) plus one gate threshold voltage ($V_{th}$) as the said gate control voltage.

6. A voltage converting circuit as claimed in claim 1, comprising:—

first ($Q_1$ and second ($Q_4$) output MIS transistors, each having a gate, and respectively having terminals connected to the first ($V_{cc}$) and second ($V_{ss}$) power source lines, and respectively having terminals for delivering first and second converted output voltages corresponding to first and second predetermined fractions of the power supply voltage respectively; and

first ($R_1$, $R_2$, $Q_2$, $Q_3$) and second ($R_3$, $R_4$, $Q_5$, $Q_6$) gate control means, for providing the gates of the first ($Q_1$) and second ($Q_4$) output MIS transistors respectively with first and second gate control voltages, respectively comprising first ($R_1$, $R_2$) and second ($R_3$, $R_4$) series connections of impedance elements between the first ($V_{cc}$) and second ($V_{ss}$) power source lines, operable to provide first and second voltage divisions in accordance with the first and second predetermined fractions respectively, each series connection further comprising first ($Q_2$; $Q_6$) and second ($Q_3$, $Q_5$) compensation MIS transistors.

7. A voltage converting circuit as claimed in claim 6, wherein the first output MIS transistor and the or each first compensation transistor is an N channel MIS transistor, and the second output MIS transistor and the or each second compensation transistor comprises a P channel MIS transistor.

8. A voltage converting circuit as claimed in claim 6 or 7, wherein the first and second output voltages are substantially equal, the first and second predetermined proportional divisions being slightly different from one another, so that the first ($Q_1$) and second ($Q_4$) output MIS transistors, connected in series between the first ($V_{cc}$) and second ($V_{ss}$) power supply lines are never both ON at the same time.

9. A voltage converting circuit as claimed in claim 1, wherein respective impedance elements ($R_1$, $R_2$) are connected directly to the respective first ($V_{cc}$) and second ($V_{ss}$) power supply lines and the or each compensation MIS transistor element ($Q_1$) is connected between those respective impedance elements ($R_1$, $R_2$).

**Patentansprüche**

1. Spannungsumformerschaltung, zur Verbindung mit ersten ($V_{cc}$) und zweiten ($V_{ss}$) Energieversorgungsleitungen, die zwischen einander eine Energieversorgungsspannung ($V_{cc}$) führen, wenn eine Energieversorgung mit den Leitenden verbunden ist, die im Betrieb eine umgeformte Ausgangsspannung ($V_{cc}'$) von einem Pegel ($mV_{cc}/n$) liefern, der einen vorbestimmten Bruchteil (m/n) der Energieversorgungsspannung ($V_{cc}$) ist, welche Schaltung umfaßt:—

einen Ausgangs-MIS-Transistor ($Q_1$, $Q_4$), der ein Gate, einen mit der Energieversorgungsleitung verbundenen Anschluß und einen Anschluß zur Lieferung der genannten umgeformten Ausgangsspannung ($V_{cc}'$) hat; und

Gate-Steuereinrichtungen ($R_1$, $R_2$, $Q_2$, $Q_3$; $R_3$, $R_4$, $Q_5$, $Q_6$; $R_1$, $R_2$, $Q_2$, $Q_3$, $Q_7$; $R_1$, $R_2$, $Q_2$, $Q_3$, $Q_7$, $Q_8$; $T_1$ bis $T_n$, $T_1$, bis $T_n'$, $Q_2$, $Q_3$), die betätigbar sind, um dem Gate des Ausgangs-MIS-Transistors ($Q_1$, $Q_4$) eine Gatesteuerspannung zu liefern, mit einer Reihenverbindung, zwischen der ersten ($V_{cc}$) und der zweiten ($V_{ss}$) Energieversorgungsleitung, von Impedanzelementen ($R_1$, $R_2$; $R_3$, $R_4$; $T_1$ bis $T_n$; $T_1'$ bis $T_n'$), die betreibbar ist, um eine Spannungsteilung in Übereinstimmung mit dem genannten vorbestimmten Bruchteil zu liefern, dadurch gekennzeichnet, daß

die Reihenverbindung ferner wenigstens einen Kompensations-MIS-Transistor ($Q_2$, $Q_3$; $Q_5$, $Q_6$; $Q_2$, $Q_3$, $Q_7$) umfaßt, so daß die Spannung eines Knotens ($N_1$) zwischen zwei Elementen der Reihenverbindung von dem Pegel der genannten umgeformten Ausgangsspannung um einen Betrag verschieden ist, der von der Schwellenwertspannung des Gate des MIS-Transistors abhängt, wobei die Spannung des genannten Knotens ($N_1$) verwendet wird, um die genannte Gate-Steuerspannung zu liefern, wodurch der genannte Pegel der umgeformten Ausgangsspannung ($V_{cc}'$) unabhängig von dem Wert der Gate-Schwellenwertspannung des MIS-Transistors geliefert wird, durch wechselseitiges Löschen des Effektes eines Fehlers in der Gate-Schwellenwertspannung ($V_{th}$, $V_{thp}$) des Ausgangs-MIS-Transistors ($Q_1$, $Q_4$) beim Betrieb von demjenigen Transistor, und dem Effekt von solch einem Fehler in der Gate-Schwellenwertspannung auf die Spannung von dem genannten Knoten ($N_1$).

2. Spannungsumformerschaltung nach Anspruch 1, bei der die Impedanzelemente eine Vielzahl von Widerstandselementen ($R_1$, $R_2$; $R_3$, $R_4$) umfassen.

3. Spannungsumformerschaltung nach Anspruch 1, bei der die Impedanzelemente eine Vielzahl von MIS-Transistoren ($T_1$ bis $T_n$, $T_1'$ bis $T_n'$) vom Verarmumgstyp umfassen.

4. Spannungsumformerschaltung nach Anspruch 1, 2 oder 3, bei der die Reihenverbindung eine Vielzahl von Kompensations-MIS-Transistoren ($Q_2$, $Q_3$; $Q_5$, $Q_6$, $Q_2$, $Q_3$, $Q_7$) umfaßt, wobei die Zahl (n) von diesen in Übereinstimmung mit dem genannten vorbestimmten Bruchteil ausgewählt ist.

5. Spannungsumformerschaltung nach einem der vorhergehenden Ansprüche, bei der die Reihenverbindung eine Vielzahl von ersten Kompensations-MIS-Transistoren ($Q_2$, $Q_3$; $Q_5$, $Q_6$; $Q_2$, $Q_3$, $Q_7$) umfaßt, und bei der die Gate-Steuereinrichtung ferner wenigstens einen zweiten Kompensations-MIS-Transistor ($Q_8$) umfaßt, der zwischen dem Gate des Ausgangs-MIS-Transistors und der Energieversorgungsleitung verbunden ist, mit der ein Anschluß des Ausgangs-MIS-Transistors verbunden ist, wobei sein Gate mit dem genannten Knoten ($N_1$) verbunden ist, die Anzahl (n) der ersten Kompensations-MIS-Transistoren so angeordnet sind, daß sie dem Gate des Ausgangs-MIS-Transistors ($Q_1$) eine Spannung zuführen, mit einem Pegel von der konstanten umgeformten Ausgangsspannung ($V_{cc}'$) plus einer Gate-Schwellenwertspannung ($V_{th}$) wie die Gatesteuerspannung.

6. Spannungsumformerschaltung nach Anspruch 1, mit:—

ersten ($Q_1$) und zweiten ($Q_4$) Ausgangs-MIS-Transistoren, die jeweils ein Gate haben und jeweils Anschlüsse haben, die mit der ersten ($V_{cc}$) bzw. zweiten ($V_{ss}$) Energiequellenleitung verbunden sind, und jeweils Anschlüsse haben, um erste und zweite umgeformte Ausgangsspannungen zu liefern, die ersten bzw. zweiten Bruchteilen der Energieversorgungsspannung entsprechen und;

ersten $R_1$, $R_2$, $Q_2$, $Q_3$) und zweiten ($R_3$, $R_4$, $Q_5$, $Q_6$) Gate-Steuereinrichtungen, um den Gates der ersten ($Q_1$) bzw. zweiten ($Q_4$) Ausgangs-MIS-Transistoren eine erste bzw. eine zweite Gate-Steuerspannung zuzuführen, die erste ($R_1$, $R_2$) bzw. zweite ($R_3$, $R_4$) Reihenverbindungen von Impedanzelementen zwischen der ersten ($V_{cc}$) und zweiten ($V_{ss}$) Energieleitung umfassen, die betreibbar sind, um erste und zweite Spannungsteilungen in Übereinstimmung mit den ersten bzw. zweiten vorbestimmten Bruchteilen zu liefern, wobei jede Reihenverbindung ferner erste ($Q_2$; $Q_6$) und zweite ($Q_3$, $Q_5$) Kompensations-MIS-Transistoren umfaßt.

7. Spannungsumformerschaltung nach Anspruch 6, bei der der ersten Ausgangs-MIS-Transistor und der oder jeder erste Kompensationstransistor ein N-Kanal-MIS-Transistor ist, und der zweite Ausgangs-MIS-Transistor und der oder jeder zweite Kompensationstransistor einen p-Kanal-MIS-Transistor umfaßt.

8. Spannungsumformerschaltung nach Anspruch 6 oder 7, bei der die ersten oder zweiten Ausgangsspannungen im wesentlichen gleich sind, die ersten und zweiten vorbestimmten Proportionalteilungen leicht voneinander verschieden sind, so daß der erste ($Q_1$) und zweite ($Q_4$) Ausgangs-MIS-Transistor, die in Reihe zwischen der ersten ($V_{cc}$) und zweiten ($V_{ss}$) Energieversorgungsleitung angeschlossen sind, niemals beide zur selben Zeit AN sind.

9. Spannungsumformerschaltung nach Anspruch 1, bei der jeweilige Impedanzelemente ($R_1$, $R_2$) direkt mit der entsprechenden ersten ($V_{cc}$) bzw. zweiten ($V_{ss}$) Energieversorgungsleitung verbunden sind und das oder jedes Kompensations-MIS-Transistorelement ($Q_1$) zwischen jenen entsprechenden Impedanzelementen ($R_1$, $R_2$) verbunden ist.

**Revendications**

1. Circuit de conversion de tension destiné à être connecté à une première (Vcc) et une seconde ($V_{ss}$) lignes d'alimentation produisant une tension d'alimentation (Vcc) entre elles lorsqu'une source d'alimentation est connectée aux lignes, ayant pour fonction, en utilisation, de produire une tension de sortie convertie (Vcc') d'un niveau (mVcc/n) qui est une fraction prédéterminée (m/n) de la tension d'alimentation (Vcc), le circuit comportant:

un transistor MIS de sortie (Q1, Q4) comprenant une grille, une borne connectée à une ligne d'alimentation et une borne qui délivre ladite tension de sortie convertie (Vcc'); et

un dispositif de commande de grille (R1, R2, Q2, Q3; R3, R4, Q5, Q6; R1, R2, Q2, Q3, Q7; R1, R2, Q2, Q3, Q7, Q8; T1 à Tn, T1' à Tn', Q2, Q3) qui applique à la grille du transistor MIS de sortie (Q1, Q4) une tension de commande de grille, comprenant une connexion en série entre la première (Vcc) et la seconde (Vss) lignes d'alimentation, d'éléments d'impédance (R1, R2; R3, R4; T1 à Tn' à Tn') ayant pour fonction de produire une division de tension en fonction de ladite fraction prédéterminée, caractérisé en ce que:

la connexion en série comporte en outre au moins un transistor MIS de compensation (Q2, Q3; Q5, Q6; Q2, Q3, Q7) de manière que la tension en un point (N1) entre deux éléments de la connexion én série diffère du niveau de ladite tension de sortie convertie d'une valeur qui dépend de la tension seuil de grille du transistor MIS, la tension audit point (N1) étant utilisée pour produire ladite tension de commande de grille de manière que ledit niveau de la tension de sortie convertie (Vcc') soit produit indépendamment de la valeur de la tension seuil de grille du transistor MIS, par annulation mutuelle de l'effet d'une erreur dans la tension seuil de grille (Vth, Vthp) du transistor MIS de sortie (Q1, Q4) sur le fonctionnement de ce transistor et l'effet de cette erreur de tension seuil de grille sur la tension audit point (N1).

2. Circuit de conversion de tension selon la revendication 1, dans lequel les éléments d'impédance consistent en plusieurs éléments de résistances (R1, R2; R3, R4).

3. Circuit de conversion de tension selon la revendication 1, dans lequel les éléments d'impédance consistent en plusieurs transistors MIS appauvris (T1 à Tn, T1' à Tn').

4. Circuit de conversion de tension selon la revendication 1, 2 ou 3 dans lequel la connexion en série comporte plusieurs transistors MIS de compensation (Q2, Q3; Q5; Q6; Q2, Q3, Q7) dont le nombre n est choisi en fonction de ladite fraction prédéterminée.

5. Circuit de conversion de tension selon

l'une quelconque des revendications précédentes, dans lequel la connexion en série comporte plusieurs premiers transistors MIS de compensation (Q2, Q3; Q5, Q6; Q2, Q3, Q7) et dans lequel le dispositif de commande de grille comporte en outre au moins un second transistor MIS de compensation (Q8) connecté entre la grille du transistor MIS de sortie et la ligne d'alimentation à laquelle est connectée une borne du transistor MIS de sortie, avec sa grille connectée audit point (N1), le nombre n du premier ou des premiers transistors MIS de compensation étant choisi de manière à fournir à la grille du transistor MIS de sortie (Q1) une tension ayant un niveau de la tension de sortie convertie constante (Vcc') augmentée d'une tension seuil de grille (Vth) comme tension de commande de grille.

6. Circuit de conversion de tension selon la revendication 1, comportant:

un premier (Q1) et un second (Q4) transistors MIS de sortie, comprenant chacun une grille et respectivement des bornes connectées à la première (Vcc) et la seconde (Vss) lignes d'alimentation et respectivement des bornes pour délivrer une première et une seconde tensions de sortie converties correspondant à une première et une seconde fractions prédéterminées de la tension d'alimentation respectivement; et

un premier (R1, R2, Q2, Q3) et un second (R3, R4, Q5, Q6) dispositifs de commande de grille fournissant aux grilles du premier (Q1) et du second (Q4) transistors MIS de sortie respectivement une première et une seconde tensions de commande de grille, comportant respectivement une première (R1, R2) et une seconde (R3, R4) connexions en série d'éléments d'impédance entre la première (Vcc) et la second (Vss) lignes d'alimentation, ayant pour fonction de produire une première et une seconde division de tension en fonction respectivement de la première et la second fractions prédéterminées, chaque connexion en série comportant en outre un premier (Q2; Q6) et un second (Q3, Q5) transistors MIS de compensation.

7. Circuit de conversion de tension selon la revendication 6, dans lequel le premier transistor MIS de sortie et le ou chaque premier transistors de compensation est un transistor MIS à canal N et le second transistor MIS de sortie et le ou chaque second transistor de compensation consiste en un transistor MIS à canal P.

8. Circuit de conversion de tension selon la revendication 6 ou 7, dans lequel la première et la seconde tensions de sortie sont pratiquement égales, la première et la seconde divisions proportionnelles prédéterminées étant légèrement différentes, l'une de l'autre, de manière que le premier (Q1) et le second (Q4) transistors MIS de sortie connectés en série entre la première (Vcc) et la seconde (Vss) lignes d'alimentation ne soient jamais débloqués en même temps.

9. Circuit de conversion de tension selon la revendication 1, dans lequel les éléments d'impédance respectifs (R1, R2) sont connectés directement à la première (Vcc) et la seconde (Vss) lignes d'alimentation respectives et le ou chaque élément de transistor MIS de compensation (Q1) est connecté entre ces éléments d'impédance respectifs (R1, R2).

Fig. 1

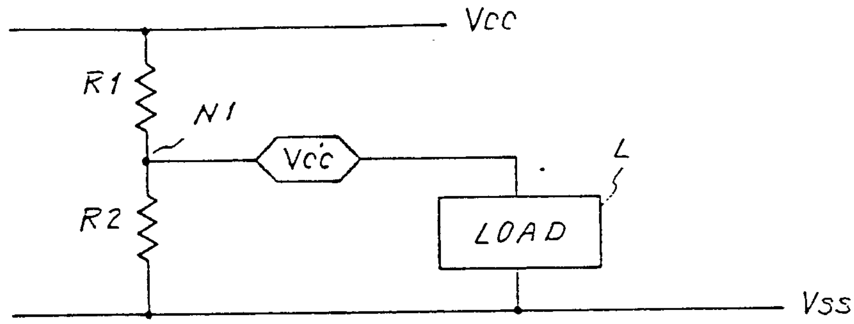


Fig. 2

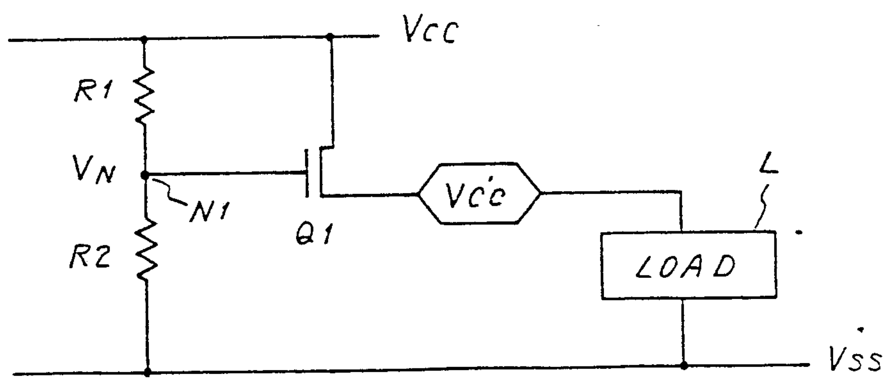

Fig. 3

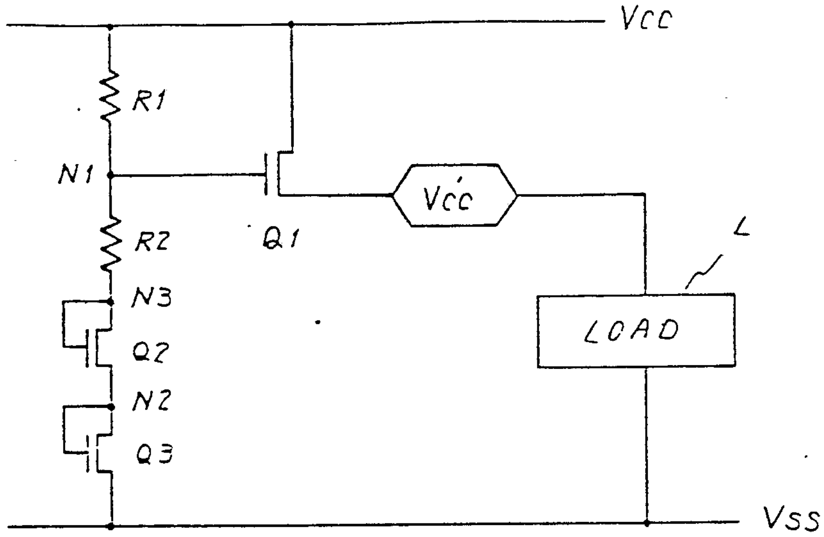
Vcc
R1
N1
R2
Q1
V'cc
L
N3
Q2
LOAD
N2
Q3
Vss

Fig. 4

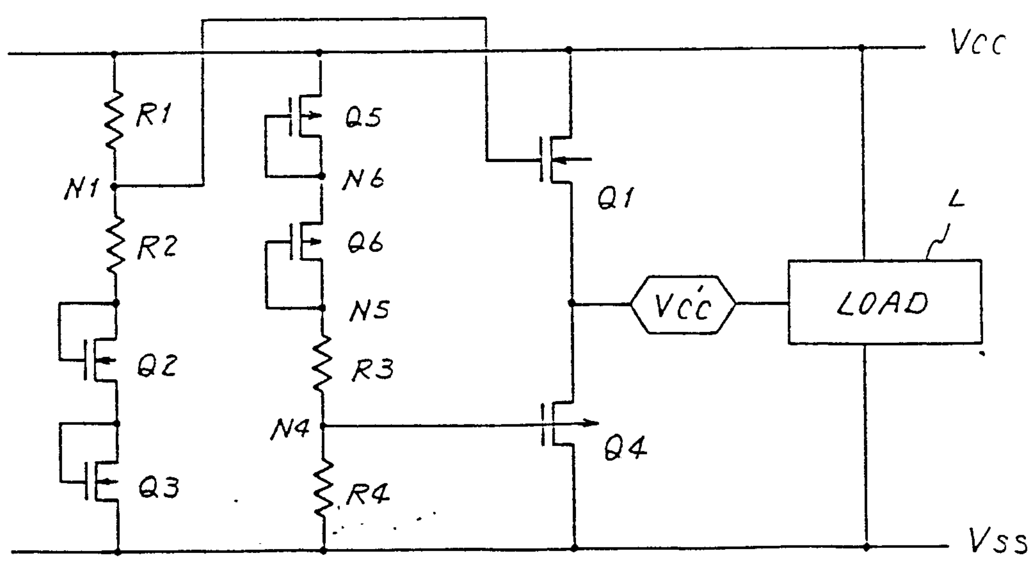
Vcc
R1
Q5
N1
N6
Q1
L
R2
Q6
N5
V'cc
LOAD
Q2
R3
N4
Q4
Q3
R4
Vss

Fig. 5

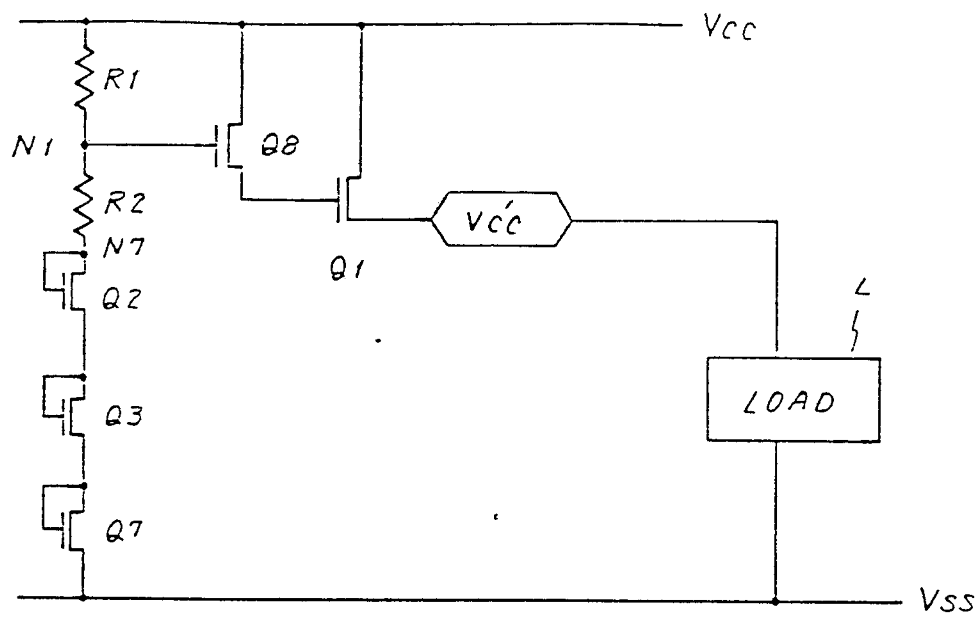
Vcc
R1
N1
Q8
R2
N7
Q2
Q1
Vc'c
L
LOAD
Q3
Q7
Vss

Fig. 6

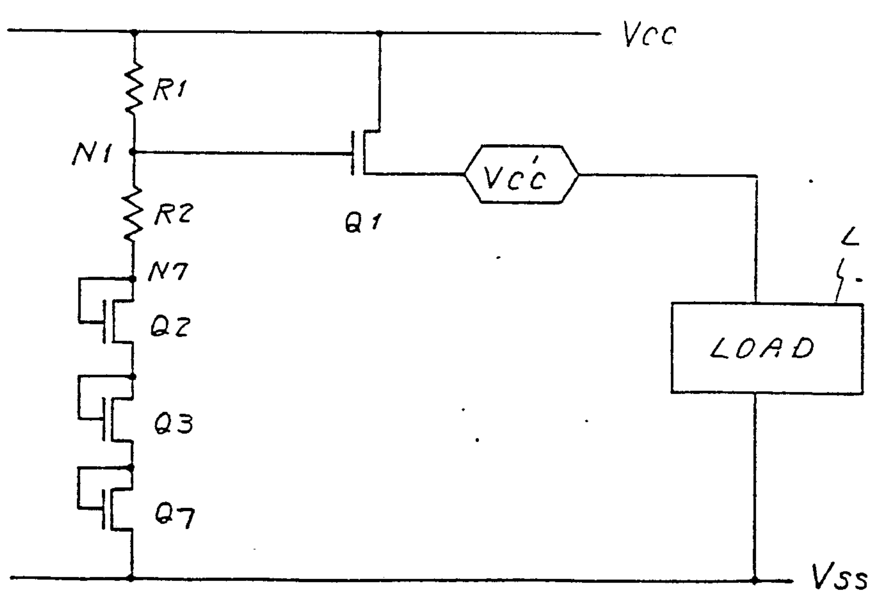
Vcc
R1
N1
R2
Q1
Vc'c
N7
Q2
L
LOAD
Q3
Q7
Vss

Fig. 7

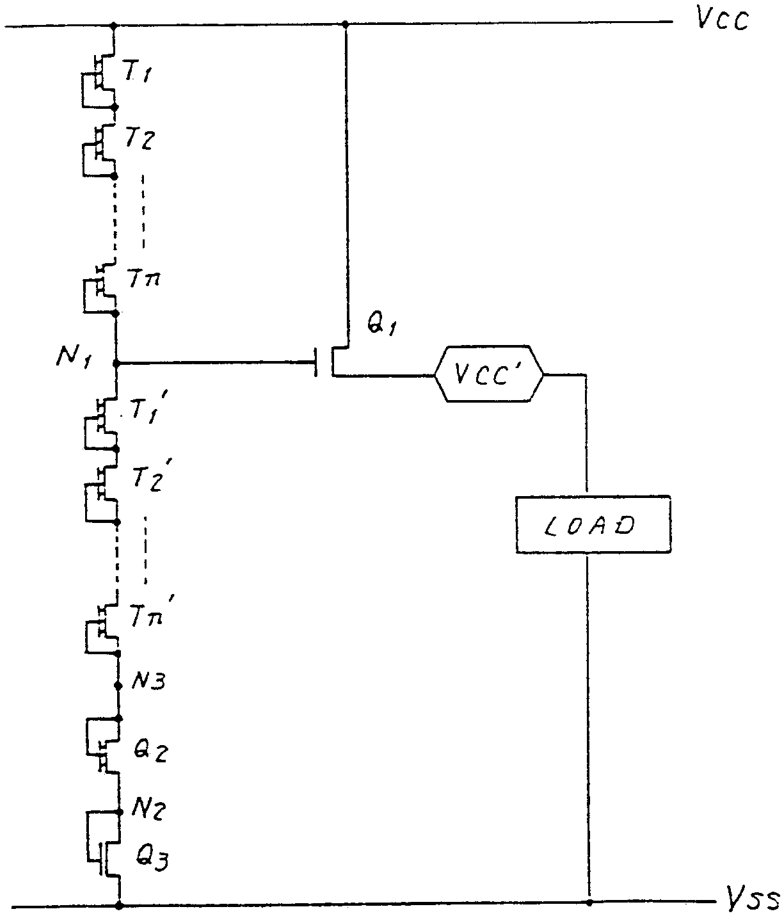

Fig. 8